# EUROPÄISCHE PATENTSCHRIFT

(11) **EP 0 526 702 B1**
(45) Veröffentlichungstag und Bekanntmachung des Hinweises auf die Patenterteilung: **07.02.1996**
(21) Anmeldenummer: 92108742.5
(22) Anmeldetag: 23.05.1992
(51) Int. Cl.: C23C 14/50, C23C 14/56, C04B 41/88

(54) **Vorrichtung zum Beschichten von Langfasern**
Apparatus for coating long fibres
Dispositif pour le revêtement des fibres longues

(30) Priorität: 12.06.1991 DE 4119307
(43) Veröffentlichungstag der Anmeldung: 10.02.1993
(73) Patentinhaber: MTU MOTOREN- UND TURBINEN-UNION MÜNCHEN GMBH, D-80976 München (DE)
(72) Erfinder: Wei, William, Dr., W-8000 München 40 (DE)

(56) Entgegenhaltungen:
- EP-A- 0 423 996
- DE-A- 1 521 250
- DE-C- 747 373

## Beschreibung

Die Erfindung betrifft eine Sputter- bzw. Vakuumbedampfungseinrichtung zum Beschichten von Langfasern.

Eine Langfaserbeschichtungseinrichtung ist aus US-PS 4,415,609 bekannt. Die Langfaser wird zur Beschichtung von einer Spule abgewikkelt, durch den Beschichtungsbehälter geführt und auf eine zweite Spule nach dem Beschichtungsvorgang aufgewickelt. Diese Einrichtung hat den Nachteil, daß für die Langfaser aufwendige gasdichte Durchführungen im Beschichtungsbehälter vorzusehen sind. Ferner wird die Langfaser durch den Durchziehvorgang und das Ab- und Aufwickeln stark belastet. Beim Bruch der Langfaser und am Ende einer Fertigungslänge muß der Beschichtungsprozeß nachteilig unterbrochen werden.

Bei mehrlagigen Beschichtungen aus Metallgrundierungen und metallischer Schicht müssen darüber hinaus nachteilig mehrere Bedampfungskammern hintereinander geschaltet werden, durch die die Langfaser hindurch zu ziehen ist.

Aus DE 74 73 73 ist eine Einrichtung zur Behandlung von Drähten mit einer Rolle mit exzentrisch in Aussparungen der Rolle gelagerten, während der Behandlung verdrehbaren, gegebenenfalls geriffelten Nebenrollen bekannt. Rolle und Nebenrollen sind auf ihren nach außen zeigenden Flächen mit dem Draht für die Behandlung zu bewickeln.

Aufgabe der Erfindung ist es, eine Vorrichtung zur Beschichtung begrenzter Fertigungslängen von Langfasern anzugeben, die eine Beschichtung ohne hohen apparativen Aufwand ermöglicht und die mechanischen Belastungen beim Beschichtungsvorgang in Sputteranlagen oder Vakuumaufdampfanlagen sowie die Bruchgefahr der Langfaser beim Beschichtungsprozeß vermindert.

Gelöst wird diese Aufgabe durch eine Sputter-, bzw. Vakuumbedampfungseinrichtung zum Beschichten von Langfasern, wobei die Einrichtung einen rotationssymmetrischen Aufnahmekäfig umfaßt, welcher zur Aufnahme von Langfaserwindungen der Langfasern ausgebildet ist und aus Stegen aufgebaut ist, die durch wenigstens 3 Gewindestangen in axialem Abstand gehalten werden, wobei im Gebrauch die Langfasern ohne zusätzliche Hilfsmittel zu gleichmäßig beabstandeten Windungen innerhalb des Aufnahmekäfigs in den Gewindekerben der Gewindestangen fixiert sind.

Diese Vorrichtung hat den Vorteil, daß eine Langfaser in voller Länge von beispielsweise 300 m und in einem Beschichtungsvorgang ummantelt werden kann. Vakuumdurchführungen für die Faser entfallen ebenso wie Steuerungs- und Regelungseinrichtungen für ein kontinuierliches Ab- und Aufwickeln der Langfaser. Ein weiterer Vorteil ist, daß mit dieser Vorrichtung der Querschntit der beschichteten Langfaser als Verbundfaser von annähernd kreisförmig bis extrem oval oder elliptisch eingestellt werden kann. Selbst asymmetrische Querschnitte sind möglich.

Diese Einstellbarkeit der Querschnitte ist von besonderem Vorteil bei der Weiterverarbeitung der beschichteten Fasern zu Bauteilen aus Verbundwerkstoffen. Wird eine derart mit Metallmatrix beschichtete Faser zur Herstellung von Bauteilen aus Kohle- oder Siliziumkabidfaser verstärkten Metallen wie Titan eingesetzt, so kann die Packungsdichte und Anordnugn der Fasern im Verbundwerkstoff richtungsabhängig gestaltet werden.

In einer bevorzugten Ausbildung der Vorrichtung sind die Gewindestangen radial verstellbar zwischen den Stegen angeordnet. Dadurch läßt sich vorteilhaft der Radius für ein Wickeln der Langfaser zu einer Spule an die physikalischen Eigenschaften der Faser anpassen.

Nach unten wird der Wickelradiaus durch den zulässigen Biegeradius der Langfaser begrenzt. Nach oben ist der Wickel radius durch die Forderung begrenzt, daß sich die Langfaser ohne zusätzliche Hilfsmittel durch die eigene Federkraft bzw. Elastizität zu gleichmäßig beabstandeten Windungen innerhalb des Aufnahmekäfigs in den Gewindekerben der Gewindestangen durch Andruck fixiert.

Mit einer bevorzugten Ausbildung der Erfindung, bei der die Gewindestangen axial gleichmäßig beabstandete, tangential zur Innenseite des Aufnahmekäfigs eingebrachte Nuten aufweisen wird vorteilhaft die Langfaser in gleichmäßig beabstandete Windungen innerhalb des Aufnahmekäfigs aufgenommen. Gewindekerben werden damit in diesem Bereich der Gewindestangen entbehrlich.

In einer weiteren bevorzugtne Ausbildung der Erfindung sind die Stege als Ringe oder Scheiben ausgebildet und weisen mindestens 3 auf dem Umfang verteilte Aufnehmer für die Gewindestangen auf. In der einfachsten Ausbildung bestehen die Aufnehmer aus am Umfang'der Ringe oder Scheiben verteilten Bohrungen, Gewindebohrungen oder Axialnuten zur Befestigung der Gewindestangen an den Stegen. Die Aufnehmer an den Stegen für die Gewindestangen können aber auch als Klemm- oder Schnellverschlüsse ausgebildet sein, womit vorteilhaft eine schnelle und sichere Positionierung der Langfaser innerhalb des Aufnahmekäfigs möglich wird.

Die Beschichtung in Sputter- oder Vakuumaufdampfanlagen geht von einer Beschichtungsquelle aus. In einer bevorzugten Weiterbildung der Erfindung ist deshalb der Aufnahmekäfig für die Langfaser um seine Achse drehbar gelagert. Damit wird vorteilhaft erreicht, daß mittels einer aufgeprägten Drehbewegung des Aufnahmekäfigs die gesamte Langfaser der Beschichtungsquelle zugewandt werden kann.

Die beschichtete Langfaser zeigt als Verbundfaser in diesem Fall einen extrem unsymmetrischen Querschnitt, was durchaus für begrenzte Anwendungen ein Vorteil ist.

Eine bevorzugte Weiterbildung der Erfindung besteht darin, den Aufnahmekäfig der Langfaser zwischen zwei Sputterquellen drehbar anzuordnen, wobei sich eine Quelle radial innerhalb des Aufnahmekäfigs und die andere radial außerhalb des Aufnahmekäfigs befindet. Diese Weiterbildung hat den Vorteil, daß annähernd runde oder ovale oder äußerst symmetrische aber flache Querschnitte für eine Verbundfaser erreicht werden.

In Vakuumbedampfungsanlagen ist prinzipiell auch eine Trennung der Innen- und Außenbeschichtung der in Windungen angeordneten Langfaser durch örtliche Aufteilung der Schmelze auf einen Verdampfungsbereich innerhalb und außerhalb des Aufnahmekäfigs für die Langfaser möglich. Eine bevorzugte Weiterbildung der Erfindung sieht vor, daß der Aufnahmekäfig in einer Taumeleinrichtung drehbar oberhalb einer Schmelze einer Vakuumbedampfungsanlage angeordnet ist. Dadurch entfällt vorteilhaft die Bereitstellung einer zweiten Schmelze in der Vakuumbedampfungsanlage.

Die Vorrichtung wird vorzugsweise zur mehrlagigen Beschichtung von Langfasern aus hochelastischem anorganischem Material mit einer Metallgrundierung und einer metallischen Schicht, vorzugsweise aus Titan eingesetzt. Die hochelastische anorganische Langfaser wird nach der Beschichtung für faserverstärkte Metallbauteile verwendet. Eine bevorzugte Langfaser besteht aus Kohle oder Siliciumkarbid.

Die folgenden Fig. zeigen beispielhaft bevorzugte Ausbildungen der Erfindung.
Fig. 1 zeigt die Vorrichtung in einer Sputteranlage
Fig. 2 zeigt die Vorrichtung in einer Vakuumaufdampfanlage

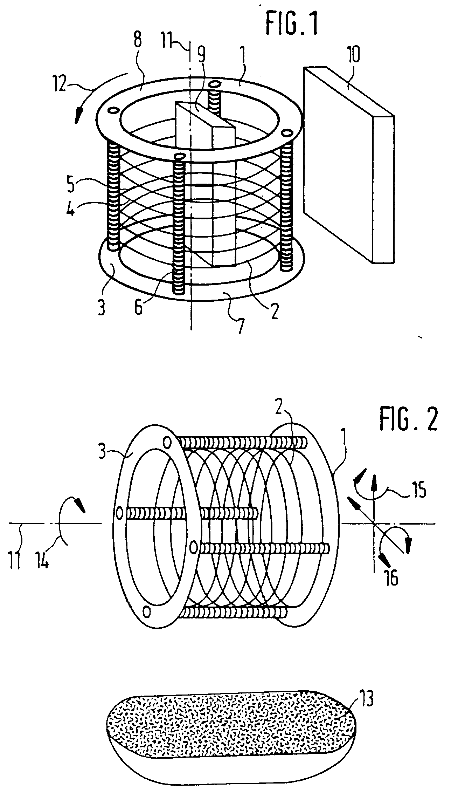

Fig. 1 zeigt die Vorrichtung 1 in einer Sputteranlage. Eine Langfaser 2 von beispielsweise 100m Länge ist innerhalb eines Aufnahmekäfigs 3 mit einem Radius von beispielsweise 300mm in gleichmäßig beabstandeten Windungen gehalten. Die gleichmäßige Beabstandung zwischen Langfaserwindungen 4 und 5 wird durch die Gewindekerben der Gewindestangen 6 erreicht, die zwischen zwei Stegen 7 und 8 angeordnet sind. Die Anzahl der Gewindestangen 6 des Aufnahmekäfigs 3 richtet sich nach der Federsteifigkeit der Langfaser die beispielsweise im Fall einer Siliciumkarbidfaser so hoch ist, daß vier Gewindestangen 6 ausreichen, um die Position einer Langfaserwindung 4 bei einem Windungsradius von 300mm zu sichern.

Die Stege 1 und 3 sind als Ringe ausgebildet. Der innere Ringdurchmesser ist in diesem Beispiel so bemessen, daß eine Sputterquelle 9 im Zentrum des Aufnahmekäfigs 3 positioniert werden kann. Außerhalb des Aufnahmekäfigs 3 weist die Sputteranlage eine zweite Sputterquelle 10 auf, so daß die Langfaser 2 bei Drehung des Aufnahmekäfigs 3 um seine Achse 11 in Pfeilrichtung 12 allseitig beschichtet wird.

Fig. 2 zeigt die Vorrichtung 1 in einer Vakuumaufdampfanlage. Der Aufnahmekäfig 3 wird in einer Taumeleinrichtung über einer Ti-Schmelze 13 um ihre drei Raumachsen 11,15 und 16 geschwenkt, so daß die Windungen einer Langfaser aus Siliziumkarbid mit einer Metallgrundierung allseits mit Titan beschichtet wird.

## Patentansprüche

1. Sputter-, bzw. Vakuumbedampfungseinrichtung zum Beschichten von Langfasern, dadurch gekennzeichnet, daß sie einen rotationssymmetrischen Aufnahmekäfig (3) umfaßt, welcher zur Aufnahme von Langfaserwindungen (4,5) der Langfasern (2) ausgebildet ist und aus Stegen (7,8) aufgebaut ist, die durch wenigstens 3 Gewindestangen (6) in axialem Abstand gehalten werden, wobei im Gebrauch die Langfasern ohne zusätzliche Hilfsmittel zu gleichmäßig beabstandeten Windungen (4,5) innerhalb des Aufnahmekäfigs (3) in den Gewindekerben der Gewindestangen (6) fixiert sind.

2. Sputter-, bzw. Vakuumbedampfungseinrichtung nach Anspruch 1, dadurch gekennzeichnet, daß die Gewindestangen (6) radial verstellbar zwischen den Stegen (7,8) angeordnet sind.

3. Sputter-, bzw. Vakuumbedampfungseinrichtung nach Anspruch 1 oder 2, dadurch gekennzeichnet, daß die Gewindestangen (6) zur gleichmäßig beabstandeten Aufnahme der Langfaser (2) axial gleichmäßig beabstandete, tangential zur Innenseite des Aufnahmekäfigs (3) eingebrachte Nuten aufweisen.

4. Sputter-, bzw. Vakuumbedampfungseinrichtung nach einem der Ansprüche 1 bis 3, dadurch gekennzeichnet, daß die Stege (7,8) als Ringe oder Scheiben ausgebildet sind, die mindestens 3 auf den Umfang verteilte Aufnehmer für die Gewindestangen (6) aufweisen.

5. Sputter-, bzw. Vakuumbedampfungseinrichtung nach einem der Ansprüche 1 bis 4, dadurch gekennzeichnet, daß der Aufnahmekäfig (3) um seine Achse drehbar gelagert ist.

6. Sputtereinrichtung nach einem der Ansprüche 1 bis 5, dadurch gekennzeichnet, daß der Aufnahmekäfig (3) zwischen zwei Sputterquellen (9,10) drehbar angeordnet ist, wobei sich eine Quelle radial innerhalb (9) des Aufnahmekäfigs (3) und die andere radial außerhalb (10) des Aufnahmekäfigs (3) befindet.

7. Vakuumbedampfungseinrichtung nach einem der Ansprüche 1 bis 5, dadurch gekennzeichnet, daß der Aufnahmekäfig (3) in einer Taumeleinrichtung drehbar oberhalb einer Schmelze (13) einer Vakuumbedampfungsanlage angeordnet ist.

8. Verwendung der Sputter-, bzw. Vakuumbedampfungseinrichtung nach einem der Ansprüche 1 bis 7 zur Beschichtung einer Langfaser (2) aus hochelastischem anorganischem Material,vorzugsweise aus SiC.

9. Verwendung der Sputter-, bzw. Vakuumbedampfungseinrichtung nach einem der Ansprüche 1 bis 7, zur mehrmaligen Langfaserbeschichtung mit Metallen, vorzugsweise mit einer Metallgrundierung und einer Ti-Schicht.

## Claims

1. Sputtering or vacuum deposition device for coating long fibres, characterised in that it comprises a rotationally symmetrical holding bobbin (3), which is designed for holding coils (4, 5) of long fibres (2) and is constructed from webs (7, 8), which are kept axially spaced by at least three threaded rods (6), the long fibres being fixed during operation without additional means to form regularly spaced loops (4, 5) inside the holding cage (3) in the thread grooves of the threaded rods (6).

2. Sputtering or vacuum deposition device according to claim 1, characterised in that the threaded rods (6) are arranged to be radially adjustable between the webs (7, 8).

3. Sputtering or vacuum deposition device according to claim 1 or 2, characterised in that the threaded rods (6) have axially equally spaced grooves at a tangent to the inside of the holding cage (3) for holding the long fibres (2) at regular intervals.

4. Sputtering or vacuum deposition device according to claims 1 to 3, characterised in that the webs (7, 8) are formed as rings or discs, which have at least three receiving means for the threaded rods distributed around the circumference.

5. Sputtering or vacuum deposition device according to one of claims 1 to 4, characterised in that the holding cage (3) is rotatably mounted on its axis.

6. Sputtering device according to one of claims 1 to 5, characterised in that the holding cage (3) is rotatably arranged between two sputtering sources (9, 10), one source (9) being located radially inside the holding cage (3) and the other (10) radially outside the holding cage (3).

7. Vacuum deposition device according to one of the claims 1 to 5, characterised in that the holding cage (3) is arranged in a wobble device rotatably above a melt of a vacuum deposition device.

8. Use of the sputtering or vacuum deposition device according to one of claims 1 to 7 for coating a long fibre (2) made from highly elastic inorganic material, preferably SiC.

9. Use of the sputtering or vacuum deposition device according to one of claims 1 to 7 for multiple coating of long fibres with metals, preferably with a metal primer and a Ti-layer.

## Revendications

1. Dispositif de vaporisation sous vide pour le revêtement de fibres longues, caractérisé en ce qu'il comprend une cage réceptrice (3) à symétrie de révolution, qui est conçue pour recevoir des spires (4, 5) de fibres longues (2) et se compose de barrettes (7, 8) maintenues à distance axiale par au moins 3 tiges filetées (6), les fibres longues étant, lors de l'utilisation, immobilisées sans moyen auxiliaire supplémentaire sous forme de spires espacées (4, 5) à l'intérieur de la cage réceptrice (3) dans les entailles des filets des tiges filetées (6).

2. Dispositif de vaporisation sous vide selon la revendication 1, caractérisé en ce que les tiges filetées (6) sont disposées avec une possibilité de déplacement radial entre les barrettes (7, 8).

3. Dispositif de vaporisation sous vide selon la revendication 1 ou 2, caractérisé en ce que, pour que les fibres longues (2) soient logées avec un écartement régulier, les tiges filetées (6) comportent des gorges espacées régulièrement dans le sens axial et réalisées tangentiellement à la face intérieure de la cage réceptrice (3).

4. Dispositif de vaporisation sous vide selon l'une des revendications 1 à 3, caractérisé en ce que les barrettes (7, 8) se présentent sous la forme d'anneaux ou de disques comportant au moins 3 moyens de réception répartis sur la périphérie et destinés aux tiges filetées (6).

5. Dispositif de vaporisation sous vide selon l'une des revendications 1 à 4, caractérisé en ce que la cage réceptrice (3) est montée en rotation autour de son axe.

6. Dispositif de vaporisation sous vide selon l'une des revendications 1 à 5, caractérisé en ce que la cage réceptrice (3) est montée en rotation entre deux sources de vaporisation sous vide (9, 10), l'une des sources se trouvant radialement à l'intérieur (9) de la cage réceptrice (3) et l'autre se trouvant radialement à l'extérieur (10) de la cage réceptrice (3).

7. Dispositif de vaporisation sous vide selon l'une des revendications 1 à 5, caractérisé en ce que la cage réceptrice (3) est montée en rotation dans un dispositif à mouvement de nutation au-dessus du bain (13) d'une installation de vaporisation sous vide.

8. Mise en oeuvre du dispositif de vaporisation sous vide selon l'une des revendications 1 à 7 pour le revêtement d'une fibre longue (2) en matériau inorganique très élastique, de préférence en SiC.

9. Mise en oeuvre du dispositif de vaporisation sous vide selon l'une des revendications 1 à 7 pour le revêtement répété de fibres longues avec des métaux, de préférence avec une couche de fond métallique et une couche de Ti.
